# EUROPEAN PATENT APPLICATION

(11) **EP 4 332 268 A1**
(43) Date of publication of application: **06.03.2024**
(21) Application number: 22795227.2
(22) Date of filing: 10.02.2022
(51) Int. Cl.: C23C 18/31, H01G 4/00, H01G 4/10, H01G 9/00, H01G 9/042, H01G 9/07, H01G 9/145

(54) **MULTILAYER BODY PRODUCTION METHOD, CAPACITOR PRODUCTION METHOD, MULTILAYER BODY, CAPACITOR, ELECTRIC CIRCUIT, CIRCUIT BOARD, AND DEVICE**

(30) Priority: 28.04.2021 JP 2021076882
(71) Applicant: Panasonic Intellectual Property Management Co., Ltd., Kadoma-shi, Osaka 571-0057 (JP)
(72) Inventor: MASHIKO, Hisanori, Kadoma-shi, Osaka 571-0057 (JP); SUZUKA, Michio, Kadoma-shi, Osaka 571-0057 (JP)
(74) Representative: Eisenführ Speiser
(86) International application number: PCT/JP2022/005505
(87) International publication number: WO 2022/230304

(57) **Abstract**

A multilayer body 1a of the present disclosure includes a support 10, a bismuth-including layer 30, and an intermediate layer 20. The bismuth-including layer 30 includes at least one selected from the group consisting of pure bismuth, a bismuth alloy, bismuth oxide, and a composite oxide including bismuth. The intermediate layer 20 includes at least one selected from the group consisting of pure zinc, a zinc alloy, pure tin, a tin alloy, pure lead, and a lead alloy. Additionally, the intermediate layer 20 is disposed between the bismuth-including layer 30 and the support 10 in a thickness direction of the bismuth-including layer 30.

## Description

### TECHNICAL FIELD

The present invention relates to a multilayer body production method, a capacitor production method, a multilayer body, a capacitor, an electrical circuit, a circuit board, and an apparatus.

### BACKGROUND ART

Electrolytic capacitors including aluminum and a valve metal other than aluminum have been known.

For example, Patent Literature 1 describes an electrode foil for electrolytic capacitors, the electrode foil including a substrate made of aluminum or an aluminum alloy, a metal layer made of zirconium or hafnium, which is a valve metal, and a dielectric layer. The metal layer is positioned on the substrate. The dielectric layer is positioned on the metal layer. The dielectric layer includes: at least one of carbon, sulfur, and nitrogen; and zirconium or hafnium.

Meanwhile, electroless bismuth plating is known. For example, Patent Literature 2 describes a method for forming an electroless bismuth plating film. A plating bath containing a trivalent bismuth salt, a water-soluble divalent tin compound, and a complexing agent is used in this method. In this method, an alumina ceramic substrate and a polyimide film are subjected to electroless plating.

Non Patent Literature 1 describes the result of studying a factor affecting a deposition rate and bath stability in electroless bismuth plating. In the electroless bismuth plating described in Non Patent Literature 1, after treated with 10% sulfuric acid, a rolled copper plate is immersed in a solution containing palladium chloride and hydrochloric acid for palladium substitution. Subsequently, the rolled copper plate is immersed in a plating bath. The plating bath contains tin(II) sulfate as a reducing agent and bismuth(III) nitrate as a bismuth salt.

### CITATION LIST

### Patent Literature

Patent Literature 1: JP 2015-115475A
Patent Literature 2: JP H5-214549 A

### Non Patent Literature

Non Patent Literature 1: Ei Uchida, "Development for the autocatalytic deposition of palladium and bismuth, and study on the autocatalytic deposition of tin using contact with zinc powder in the bath", Konan University, doctoral thesis, January 2015

### SUMMARY OF INVENTION

### Technical Problem

The techniques described in Patent Literature 1, Patent Literature 2, and Non Patent Literature 1 leave room for reexamination in terms of a bismuth-related multilayer body. Therefore, the present disclosure provides a method for producing a new bismuth-related multilayer body.

### Solution to Problem

A multilayer body production method of the present disclosure includes:
forming an intermediate layer on a support; and
forming a metal layer on the intermediate layer by electroless plating, the metal layer including at least one selected from the group consisting of pure bismuth and a bismuth alloy, wherein
the intermediate layer includes at least one selected from the group consisting of pure zinc, a zinc alloy, pure tin, a tin alloy, pure lead, and a lead alloy.

### Advantageous Effects of Invention

According to the present disclosure, a method for producing a new bismuth-related multilayer body can be provided.

### BRIEF DESCRIPTION OF DRAWINGS

FIG. 1 is a cross-sectional view showing a multilayer body according to an embodiment of the present disclosure.
FIG. 2 is a cross-sectional view showing a multilayer body according to another embodiment of the present disclosure.
FIG. 3A is a cross-sectional view showing a multilayer body according to yet another embodiment of the present disclosure.
FIG. 3B is a cross-sectional view showing a multilayer body according to yet another embodiment of the present disclosure.
FIG. 3C is a cross-sectional view showing a multilayer body according to yet another embodiment of the present disclosure.
FIG. 4A is a cross-sectional view showing a capacitor according to an embodiment of the present disclosure.
FIG. 4B is a cross-sectional view showing a capacitor according to another embodiment of the present disclosure.
FIG. 4C is a cross-sectional view showing a capacitor according to yet another embodiment of the present disclosure.
FIG. 5A schematically shows an electrical circuit according to an embodiment of the present disclosure.
FIG. 5B schematically shows a circuit board according to an embodiment of the present disclosure.
FIG. 5C schematically shows an apparatus according to an embodiment of the present disclosure.
FIG. 6 is a flowchart showing an example of a multilayer body production method according to the present disclosure.
FIG. 7 is a photograph showing a first multilayer body according to Example.
FIG. 8 is a scanning electron microscope (SEM) image of a surface of a bismuth-including layer of the first multilayer body according to Example.
FIG. 9A is a SEM image showing a rupture portion of the first multilayer body according to Example and its vicinity.
FIG. 9B is a mapping image showing a distribution of bismuth in the image shown in FIG. 9A, the distribution being obtained from an energy dispersive X-ray (EDX) analysis result.
FIG. 9C is a mapping image showing a distribution of zinc in the image shown in FIG. 9A, the distribution being obtained from the EDX analysis result.
FIG. 9D is a mapping image showing a distribution of aluminum in the image shown in FIG. 9A, the distribution being obtained from the EDX analysis result.
FIG. 10 is a photograph showing a second multilayer body according to Example.
FIG. 11 is a SEM image of a rupture face of the second multilayer body according to Example viewed in an obliquely downward direction.
FIG. 12A shows X-ray diffraction (XRD) patterns of surfaces of a support, the first multilayer body, and the second multilayer body according to Example.
FIG. 12B shows estimation results for XRD patterns of pure bismuth and bismuth oxides, the estimation results being produced with reference to a literature.
FIG. 13A is a graph showing a relation between a capacitance of each of a capacitor according to Example, a capacitor according to Reference Example, and a capacitor according to Comparative Example and a frequency.
FIG. 13B is a graph showing a relation between a dielectric loss tanδ of each of the capacitor according to Example, the capacitor according to Reference Example, and the capacitor according to Comparative Example and a frequency.

### DESCRIPTION OF EMBODIMENTS

### (Findings on which the present disclosure is based)

Electrolytic capacitors such as solid electrolytic capacitors and aluminum electrolytic capacitors are a type of capacitors. Solid electrolytic capacitors can be used, for example, around central processing units (CPUs) of personal computers. Aluminum electrolytic capacitors can be included in power sources of inverters for large devices and power sources of inverters for automobiles such as hybrid cars. Capacitors, such as electrolytic capacitors, which are small in size and large in capacity are of high value.

For example, there is an electrolytic capacitor having a metal-insulator-metal (MIM) structure in which a metal, a dielectric, and either an electrolyte solution or an electrically conductive polymer are stacked. Such a capacitor is obtained, for example, by forming a dielectric coating on a metal by anodic oxidation of the metal and then placing an electrolyte solution or an electrically conductive polymer on the dielectric coating. Aluminum being a valve metal capable of being subjected to anodic oxidation can be used as the material of this capacitor. For example, aluminum oxide is formed as the dielectric by anodic oxidation. Aluminum oxide has a dielectric constant of about 8. It is conceivable to increase the capacity of the capacitor by using a material having a higher dielectric constant than aluminum oxide as the dielectric of the capacitor.

For example, bismuth oxide, which is an oxide of a valve metal, has a dielectric constant of about 40; bismuth oxide has a higher dielectric constant than aluminum oxide. However, bismuth is generally more expensive than aluminum. For electrolytic capacitors including aluminum as a valve metal, there has been established a technique for increasing the surface area of the aluminum by a method such as etching. However, it is difficult to say that such a technique has been established for bismuth.

Therefore, for example, it is conceivable to place a support and a bismuth-including layer on one another, the support including at least one selected from the group consisting of pure aluminum and an aluminum alloy. In this case, the bismuth-including layer having such a thickness that, for example, a dielectric layer can be formed by anodic oxidation is considered sufficiently thick. Thus, the amount of bismuth used can be reduced. Moreover, it is conceivable that the surface area of the support including at least one selected from the group consisting of pure aluminum and an aluminum alloy is increased by etching before the bismuth-including layer is placed thereon. This is likely to increase the surface area of the bismuth-including layer. Instead of the support, a support other than a support including at least one selected from the group consisting of pure aluminum and an aluminum alloy can be used.

One of the methods for placing a metal on another particular type of metal is plating. However, it is difficult to form a plating film uniformly by electroplating on a surface of a support having a complex shape. On the other hand, electroless plating can form a dense and uniformly thick plating film. The use of electroless plating to place a metal being a precursor of a dielectric formed by anodic oxidation has not been reported. Electroless bismuth plating is studied in Patent Literature 2 and Non Patent Literature 1. However, according to the electroless bismuth plating techniques described in these literatures, the material of a support is aluminum oxide or copper, which needs a pretreatment with palladium, an expensive rare metal.

In view of these circumstances, the present inventors made intensive studies on a technique by which a bismuth-including layer is placed on a support. Through a lot of trial and error, the present inventors have newly found that production conditions for placing a bismuth-including layer on a support and have devised the multilayer body of the present disclosure.

### (Summary of one aspect according to the present disclosure)

A multilayer body production method according to a first aspect of the present disclosure includes:
forming an intermediate layer on a support; and
forming a metal layer on the intermediate layer by electroless plating, the metal layer including at least one selected from the group consisting of pure bismuth and a bismuth alloy, wherein
the intermediate layer includes at least one selected from the group consisting of pure zinc, a zinc alloy, pure tin, a tin alloy, pure lead, and a lead alloy.

According to the first aspect, a multilayer body including a support and a bismuth-related metal layer can be produced by electroless plating.

According to a second aspect of the present disclosure, for example, in the multilayer body production method according to the first aspect, the support may include at least one selected from the group consisting of pure aluminum and an aluminum alloy. According to the second aspect, the surface area of the support is easily increased, and thus the surface area of the metal layer is likely to be large.

According to a third aspect of the present disclosure, for example, the multilayer body production method according to the first or second aspect may further include forming the intermediate layer on the support by electroless plating. According to the third aspect, the intermediate layer can be formed by electroless plating.

According to a fourth aspect of the present disclosure, for example, the multilayer body production method according to any one of the first to third aspects may further include forming an oxide layer by oxidation of at least a surface of the metal layer, the oxide layer including at least one selected from the group consisting of bismuth oxide and a composite oxide including bismuth. According to the fourth aspect, a multilayer body including an oxide layer formed by oxidation of the metal layer can be produced.

According to a fifth aspect of the present disclosure, for example, the multilayer body production method according to any one of the first to fourth aspects may further include providing a surface of the metal layer with asperities. According to the fifth aspect, the surface area of the metal layer can be increased.

A capacitor production method according to a sixth aspect of the present disclosure includes:
preparing a multilayer body, the multilayer body including a support, an intermediate layer, and a dielectric layer in this order,
disposing an electrode on the multilayer body, wherein
the dielectric layer includes at least one selected from the group consisting of bismuth oxide and a composite oxide including bismuth, and
the intermediate layer includes at least one selected from the group consisting of pure zinc, a zinc alloy, pure tin, a tin alloy, pure lead, and a lead alloy and is disposed between the dielectric layer and the support in a thickness direction of the dielectric layer.

According to the sixth aspect, a capacitor including a dielectric layer including at least one selected from the group consisting of bismuth oxide and a composite oxide including bismuth can be provided.

According to a seventh aspect of the present disclosure, for example, in the capacitor production method according to the sixth aspect, the support may include at least one selected from the group consisting of pure aluminum and an aluminum alloy. According to the seventh aspect, the surface area of the support is easily increased, and thus the surface area of the dielectric layer is likely to be large. As a result, the resulting capacitor is likely to have a high capacity.

A multilayer body according to an eighth aspect of the present disclosure includes:
a support;
a bismuth-including layer including at least one selected from the group consisting of pure bismuth, a bismuth alloy, bismuth oxide, and a composite oxide including bismuth; and
an intermediate layer including at least one selected from the group consisting of pure zinc, a zinc alloy, pure tin, a tin alloy, pure lead, and a lead alloy, the intermediate layer being disposed between the bismuth-including layer and the support in a thickness direction of the bismuth-including layer.

According to the eighth aspect, the multilayer body including the support and the bismuth-including layer can be provided because the multilayer body includes the intermediate layer including pure zinc or the like.

According to a ninth aspect of the present disclosure, for example, in the multilayer body according to the eighth aspect, the support may include at least one selected from the group consisting of pure aluminum and an aluminum alloy.

According to a tenth aspect of the present disclosure, for example, in the multilayer body according to the eighth or ninth aspect, the bismuth-including layer may include at least one selected from the group consisting of pure bismuth and a bismuth alloy. According to the tenth aspect, a multilayer body including at least one selected from the group consisting of pure bismuth and a bismuth alloy can be provided.

According to an eleventh aspect of the present disclosure, for example, in the multilayer body according to any one of the eighth to tenth aspects, the bismuth-including layer may include at least one selected from the group consisting of bismuth oxide and a composite oxide including bismuth. According to the eleventh aspect, a multilayer body including at least one selected from the group consisting of bismuth oxide and a composite oxide including bismuth can be provided.

According to a twelfth aspect of the present disclosure, for example, in the multilayer body according to any one of the eighth to eleventh aspects, the bismuth-including layer may include an oxide layer including at least one selected from the group consisting of bismuth oxide and a composite oxide including bismuth. In addition, the bismuth-including layer may include a metal layer including at least one selected from the group consisting of pure bismuth and a bismuth alloy, the metal layer being disposed between the oxide layer and the intermediate layer in a thickness direction of the oxide layer. According to the twelfth aspect, a multilayer body including a bismuth-related metal layer and an oxide layer can be provided.

According to a thirteenth aspect of the present disclosure, for example, the multilayer body according to any one of the eighth to twelfth aspects may have an uneven structure including the bismuth-including layer. According to the thirteenth aspect, the bismuth-including layer is likely to have a large surface area.

According to a fourteenth aspect of the present disclosure, for example, in the multilayer body according to any one of the eighth to thirteenth aspects, the bismuth-including layer may be an electroless plating film. According to the fourteenth aspect, the bismuth-including layer is likely to be dense and have a uniform thickness.

According to a fifteenth aspect of the present disclosure, for example, in the multilayer body according to any one of the eighth to fourteenth aspects, the intermediate layer may be an electroless plating film. According to the fifteenth aspect, the intermediate layer is likely to be dense and have a uniform thickness.

A capacitor according to a sixteenth aspect of the present disclosure includes:
the multilayer body according to any one of the eighth to fifteenth aspects; and
an electrode disposed on the bismuth-including layer, wherein
the bismuth-including layer includes an oxide layer including at least one selected from the group consisting of bismuth oxide and a composite oxide including bismuth.

According to the sixteenth aspect, the oxide layer is likely to have a high dielectric constant, and the capacitor is likely to have a high capacity.

An electrical circuit according to a seventeenth aspect of the present disclosure includes the capacitor according to the sixteenth aspect. According to the seventeenth aspect, the capacitor is likely to have a high capacity, and the properties of the electrical circuit are likely to be improved.

A circuit board according to an eighteenth aspect of the present disclosure includes the capacitor according to the sixteenth aspect. According to the eighteenth aspect, the capacitor is likely to have a high capacity, and the properties of the circuit board are likely to be improved.

An apparatus according to a nineteenth aspect of the present disclosure includes the capacitor according to the sixteenth aspect. According to the nineteenth aspect, the capacitor is likely to have a high capacity, and the properties of the apparatus are likely to be improved.

### (Embodiments)

Embodiments of the present disclosure will be described hereinafter with reference to the drawings. The present disclosure is not limited to the following embodiments.

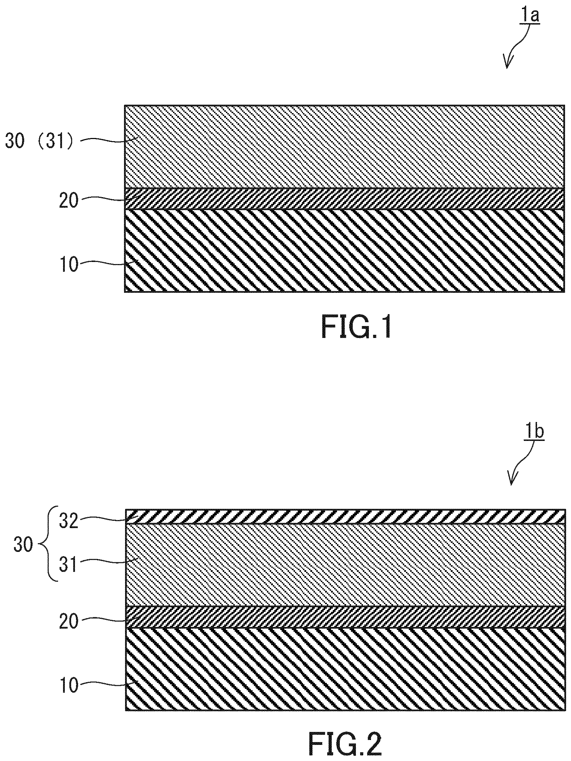

FIG. 1 is a cross-sectional view of a multilayer body according to an embodiment of the present disclosure. As shown in FIG. 1, a multilayer body 1a includes a support 10, a bismuth-including layer 30, and an intermediate layer 20. The support 10 includes, for example, at least one selected from the group consisting of pure aluminum and an aluminum alloy. The support 10 may be a plate, an aluminum foil, or an aluminum alloy foil. The support 10 may be one including a material other than pure aluminum or an aluminum alloy. The bismuth-including layer 30 includes at least one selected from the group consisting of pure bismuth, a bismuth alloy, bismuth oxide, and a composite oxide including bismuth. The intermediate layer 20 includes at least one selected from the group consisting of pure zinc, a zinc alloy, pure tin, a tin alloy, pure lead, and a lead alloy. Moreover, the intermediate layer 20 is disposed between the bismuth-including layer 30 and the support 10 in a thickness direction of the bismuth-including layer 30.

One principal surface of the intermediate layer 20 is in contact with, for example, one principal surface of the support 10. The other principal surface of the intermediate layer 20 is in contact with, for example, one principal surface of the bismuth-including layer 30.

The intermediate layer 20 is, for example, a plating film. Additionally, the bismuth-including layer 30 is, for example, a plating film. The intermediate layer 20 is, for example, an electroless plating film. The bismuth-including layer 30 is, for example, an electroless plating film. The intermediate layer 20 and the bismuth-including layer 30 are formed, for example, by electroless plating.

The intermediate layer 20 may be a film other than a plating film. For example, the intermediate layer 20 may be a vapor deposition film, a sputtered film, or another film.

It is difficult for bismuth to directly adhere to, for example, a support including at least one selected from the group consisting of pure aluminum and an aluminum alloy by electroless plating. One possible reason is that the atomic radius of bismuth and that of aluminum are very different and a difference between the lattice constant of bismuth and that of aluminum is large. Moreover, an electroless bismuth plating bath is stable in the acidic pH range. It is thought that immersion of aluminum in an acidic plating bath forms aluminum oxide on a surface of the aluminum to make it difficult for bismuth to adhere to the aluminum. Studies by the present inventors have revealed that it is possible to perform electroless bismuth plating on a given metal such as zinc or an alloy of the given metal in the acidic pH range. Moreover, since an oxide of the given metal such as zinc or an alloy of the given metal dissolves in the acidic pH range, creation of a dielectric made of such an oxide or the like between the given metal such as zinc or an alloy of the given metal and bismuth can be prevented in the acidic pH range. Since electroless bismuth plating can be performed even under a weak acid condition, a homogeneous bismuth coating is likely to be formed by adjusting a dissolving rate of the given metal such as zinc or an alloy of the given metal to be slow. Such a homogeneous coating is particularly advantageous in terms of formation of an oxide layer that can function as a dielectric of a capacitor.

For example, it is possible to allow the given metal such as zinc or an alloy of the given metal to adhere to aluminum by electroless plating. Such electroless plating can be performed in the strongly alkaline pH range. Hence, it is possible to dissolve aluminum oxide on a surface of aluminum and allow the given metal such as zinc or an alloy of the given metal to adhere to the aluminum.

The bismuth-including layer 30 includes, for example, at least one selected from the group consisting of pure bismuth and a bismuth alloy. As shown in FIG. 1, the bismuth-including layer 30 is formed, for example, as a metal layer 31, and the metal layer 31 includes at least one selected from the group consisting of pure bismuth and a bismuth alloy.

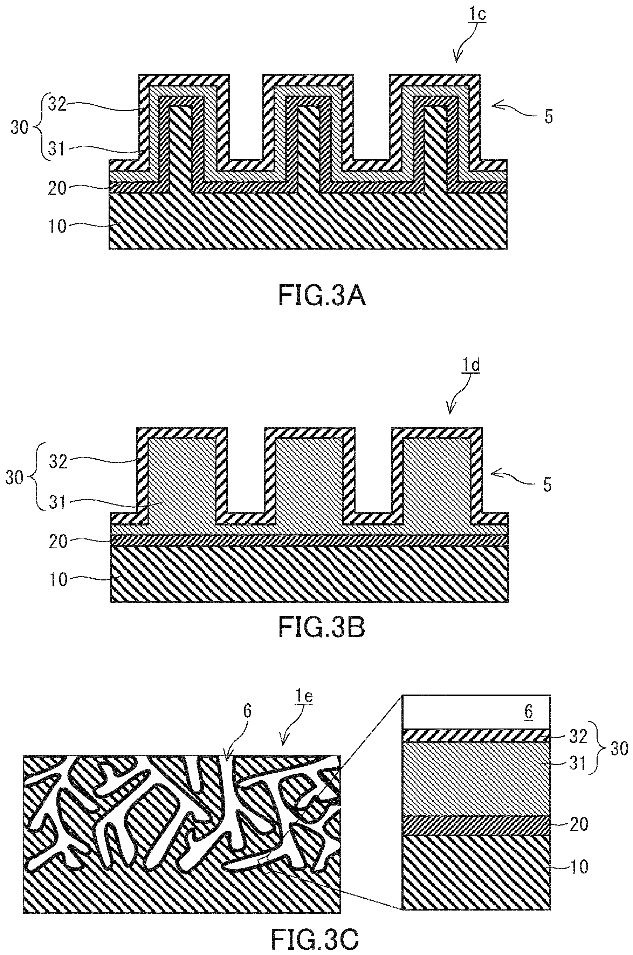

FIG. 2, FIG. 3A, and FIG. 3B are respectively cross-sectional views of multilayer bodies 1b, 1c, and 1d according to other embodiments of the present disclosure. The multilayer bodies 1b, 1c, and 1d are each configured in the same manner as the multilayer body 1a unless otherwise described. The components of the multilayer bodies 1b, 1c, and 1d that are the same as or correspond to the components of the multilayer body 1a are denoted by the same reference characters, and detailed descriptions of such components are omitted. The description given for the multilayer body 1a is applicable to the multilayer bodies 1b, 1c, and 1d unless there is a technical inconsistency.

As shown in FIG. 2, FIG. 3A, FIG. 3B, and FIG. 3C, in the multilayer bodies 1b, 1c, 1d, and 1e, the bismuth-including layer 30 includes at least one selected from the group consisting of bismuth oxide and a composite oxide including bismuth. The bismuth-including layer 30 includes, for example, the metal layer 31 and an oxide layer 32. The oxide layer 32 includes at least one selected from the group consisting of bismuth oxide and a composite oxide including bismuth. The metal layer 31 is disposed between the oxide layer 32 and the intermediate layer 20 in a thickness direction of the oxide layer 32.

Each of the multilayer bodies 1b, 1c, 1d, and 1e may be modified such that the bismuth-including layer 30 includes the metal layer 31 only or may be modified such that the bismuth-including layer 30 includes the oxide layer 32 only.

As shown in FIG. 3A and FIG. 3B, the multilayer bodies 1c and 1d each have, for example, an uneven structure 5 including the bismuth-including layer 30. This makes it likely that the bismuth-including layer 30 has a large surface area. The surface area of each of the multilayer bodies 1c and 1d having the uneven structure 5 is 1.5 to 9 times larger than that of a multilayer body without the uneven structure.

As shown in FIG. 3A, for the uneven structure 5 of the multilayer body 1c, the intermediate layer 20 and the bismuth-including layer 30 are disposed along surface asperities of one principal surface of the support 10. For example, the surface asperities can be formed by roughening the one principal surface of the support 10 by a treatment such as etching. For example, the one principal surface of the support 10 can be roughened by etching the support 10 in an etchant such as hydrochloric acid under a DC electric field or an AC electric field.

As shown in FIG. 3B, for the uneven structure 5 of the multilayer body 1d, the oxide layer 32 is disposed along surface asperities of the metal layer 31. For example, the surface asperities can be formed by roughening a surface of the metal layer 31 by a treatment such as etching. For example, the surface of the metal layer 31 of the multilayer body including the support 10, the intermediate layer 20, and the metal layer 31 can be roughened by etching the metal layer 31 in an acidic solution under a DC electric field or an AC electric field.

As shown in FIG. 3C, the multilayer body 1e is in contact with a large number of pores 6 extending from one principal surface of the multilayer body 1e toward the other principal surface thereof. In a portion of the multilayer body 1e, the intermediate layer 20 and the bismuth-including layer 30 are formed on the support 10 to be along the pore 6, the portion being in contact with the pore 6. For example, the large number of pores 6 can be formed by roughening the one principal surface of the support 10 by a treatment such as etching. For example, the one principal surface of the support 10 can be roughened by etching the support 10 in an etchant such as hydrochloric acid under a DC electric field or an AC electric field.

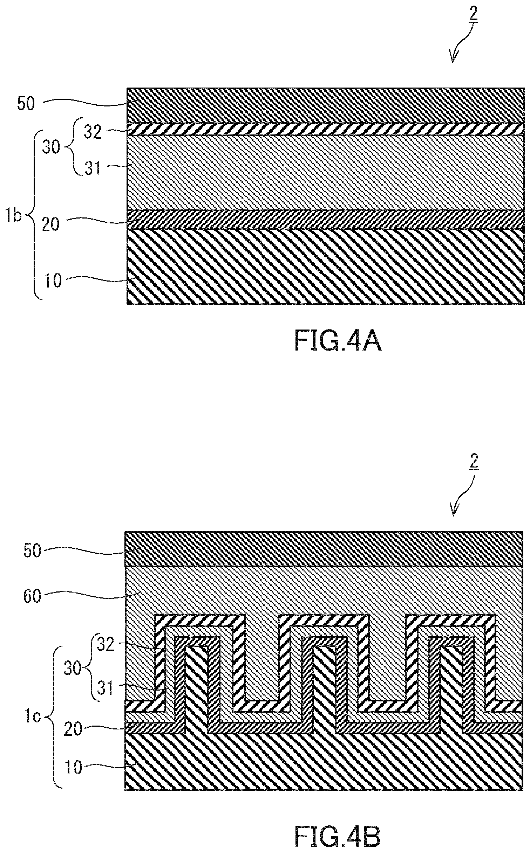

FIG. 4A is a cross-sectional view showing a capacitor according to an embodiment of the present disclosure. As shown in FIG. 4A, a capacitor 2 includes the multilayer body 1b and an electrode 50. As described above, the bismuth-including layer 30 of the multilayer body 1b includes the oxide layer 32. In the capacitor 2, the electrode 50 is disposed on the oxide layer 32. The oxide layer 32 functions as a dielectric. Since the oxide layer 32 includes at least one selected from the group consisting of bismuth oxide and a composite oxide including bismuth, the oxide layer 32 being a dielectric is likely to have a high dielectric constant. Therefore, the capacitor 2 is likely to have a high capacity.

As shown in FIG. 4A, the oxide layer 32 is disposed between the electrode 50 and the intermediate layer 20 in a thickness direction of the oxide layer 32.

In the capacitor 2, the multilayer body 1b includes an anode or a cathode. For example, a portion of the multilayer body 1b functions as an anode or a cathode, the portion being composed of the support 10, the intermediate layer 20, and the metal layer 31. The electrode 50 functions as a counter electrode in relation to the anode or the cathode included in the multilayer body 1b.

The capacitor 2 may be an electrolytic capacitor. For example, an electrolytic capacitor in which the multilayer body 1b is an anode and the electrode 50 is a cathode can be provided. The material of the cathode is, for example, aluminum. When the capacitor 2 is an electrolytic capacitor, an electrolyte solution or an electrically conductive polymer may fill a space between the multilayer body 1b and the electrode 50.

The capacitor 2 may include the multilayer body 1c, 1d, or 1e instead of the multilayer body 1b. In this case, the capacitor 2 is likely to have a higher capacity.

FIG. 4B is a cross-sectional view of the capacitor 2 according to the embodiment of the present disclosure. This capacitor 2 includes the multilayer body 1c instead of the multilayer body 1b. The capacitor 2 is configured as an electrolytic capacitor. In the capacitor 2, for example, the multilayer body 1c is an anode and the electrode 50 is a cathode. A filler 60 being an electrolyte solution or an electrically conductive polymer fills a space between the multilayer body 1c and the electrode 50.

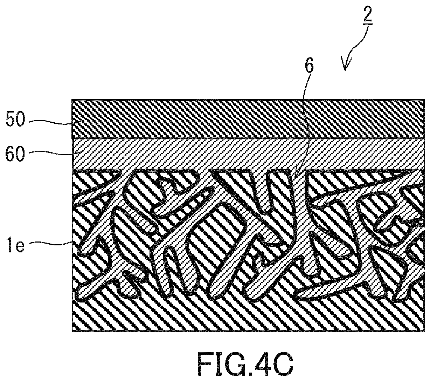

FIG. 4C is a cross-sectional view of the capacitor 2 according to the embodiment of the present disclosure. This capacitor 2 includes the multilayer body 1e instead of the multilayer body 1b. The capacitor 2 is configured as an electrolytic capacitor. In the capacitor 2, for example, the multilayer body 1e is an anode and the electrode 50 is a cathode. The filler 60 being an electrolyte solution or an electrically conductive polymer fills a space between the multilayer body 1e and the electrode 50. The filler 60 is present also in the pore 6.

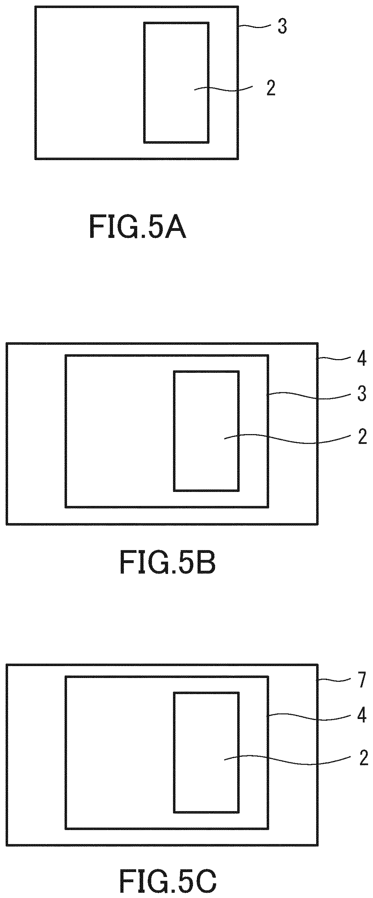

FIG. 5A schematically shows an electrical circuit 3 according to an embodiment of the present disclosure. As shown in FIG. 5A, the electrical circuit 3 includes the capacitor 2. The electrical circuit 3 is not limited to a particular circuit as long as the electrical circuit 3 includes the capacitor 2. The electrical circuit 3 may be an active circuit or a passive circuit. The electrical circuit 3 may be a discharging circuit, a smoothing circuit, a decoupling circuit, or a coupling circuit. Since the electrical circuit 3 includes the capacitor 2, the electrical circuit 3 is likely to have desired properties. For example, it is likely that the capacitor 2 reduces noise in the electrical circuit 3.

FIG. 5B schematically shows a circuit board 4 according to an embodiment of the present disclosure. As shown in FIG. 5B, the circuit board 4 includes the capacitor 2. The circuit board 4 is not limited to a particular circuit board as long as the circuit board 4 includes the capacitor 2. The circuit board 4 includes, for example, the electrical circuit 3. The circuit board 4 may be an embedded board or a motherboard.

FIG. 5C schematically shows an apparatus 7 according to an embodiment of the present disclosure. As shown in FIG. 5C, the apparatus 7 includes the capacitor 2. The apparatus 7 is not limited to a particular apparatus as long as the apparatus 7 includes the capacitor 2. The apparatus 7 includes, for example, the circuit board 4. The apparatus 7 may be an electronic device, a communication device, a signalprocessing device, or a power-supply device. The apparatus 7 may be a server, an AC adapter, an accelerator, or a flat-panel display such as a liquid crystal display (LCD). The apparatus 7 may be a USB charger, a solid-state drive (SSD), an information terminal such as a PC, a smartphone, or a tablet PC, or an Ethernet switch.

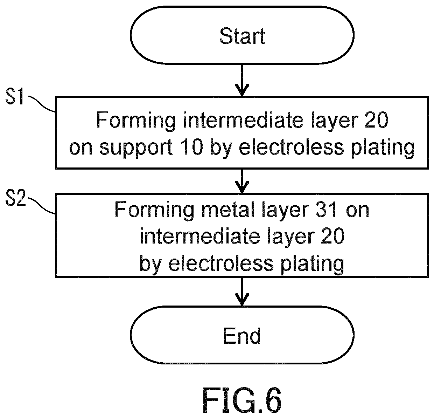

FIG. 6 is a flowchart showing an example of a multilayer body production method of the present disclosure. FIG. 6 shows, for example, a method for producing each of the multilayer bodies 1a, 1b, 1c, 1d, and 1e or a part of the method. As shown in FIG. 6, the method for producing each of the multilayer bodies 1a, 1b, 1c, 1d, and 1e includes a step S2. In the step S2, the metal layer 31 including at least one selected from the group consisting of pure bismuth and a bismuth alloy is formed on the intermediate layer 20 of a first multilayer body by electroless plating, the first multilayer body including the support 10 and the intermediate layer 20. In the first multilayer body, the support 10 includes, for example, at least one selected from the group consisting of pure aluminum and an aluminum alloy. The support 10 may be one including a material other than pure aluminum or an aluminum alloy. Additionally, the intermediate layer 20 includes at least one selected from the group consisting of pure zinc, a zinc alloy, pure tin, a tin alloy, pure lead, and a lead alloy.

As shown in FIG. 6, the method for producing each of the multilayer bodies 1a, 1b, 1c, 1d, and 1e includes, for example, a step S1. In the step S1, the intermediate layer 20 is formed on the support 10 by electroless plating. The first multilayer body including the support 10 and the intermediate layer 20 can be obtained in this manner.

As described above, the multilayer bodies 1a, 1b, 1c, 1d, and 1e can be produced, for example, by electroless plating. Electroless plating is a method for forming a metal coating film not by using an external power source but simply by soaking an object to be plated in a solution. The mechanism of electroless plating is electrochemical and does not cause a current distribution. Because of this, a plating film having a uniform thickness can be formed by electroless plating even on an object having a complex shape.

Electroless plating is roughly classified into displacement electroless plating and autocatalytic electroless plating. In displacement electroless plating, an electron released in dissolution of a metal substrate reduces a metal ion in a solution, so that a metal deposits on an object. In displacement electroless plating, a metal having a base electrode potential and a high ionization tendency is immersed in a plating solution containing a metal ion having a noble electrode potential and a low ionization tendency. A potential difference in the redox system including the two metals works as a driving force for the reaction, inducing dissolution of the metal substrate. An electrode emitted by the dissolution reduces the metal ion in the solution to cause the metal ion to deposit as a plating film. Because the reaction stops at the time that the metal depositing from the solution fully covers a surface of the metal substrate, a thickness of the plating film has an upper limit.

On the other hand, in autocatalytic electroless plating, an electron released by oxidation of a reducing agent in a solution on an object causes a metal ion in the solution to deposit as a metal coating film. In autocatalytic electroless plating, if the deposited metal has a catalytic activity for the oxidation reaction of the reducing agent, the metal deposition reaction continues. Therefore, a plating film having a desired thickness can be formed by adjusting a plating time. In the production method as shown in FIG. 6, for example, the intermediate layer 20 is formed by displacement electroless plating. Additionally, for example, the metal layer 31 is formed by a combination of displacement electroless plating and autocatalytic electroless plating.

A case where the support 10 includes aluminum, the intermediate layer 20 includes pure zinc, and the metal layer 31 includes pure bismuth is taken as an example to more specifically describe the example of the multilayer body production method.

For example, a preparation treatment of the support 10 is performed before the step S1. For example, a degreasing treatment of the support 10 is performed using an organic solvent such as acetone. In this degreasing treatment, for example, ultrasonic cleaning is performed for the support 10 immersed in the organic solvent such as acetone. Next, for example, a treatment for removing a natural oxide on a surface of the support 10 is performed. In this treatment, for example, the support 10 is immersed in a strong alkaline solution such as sodium hydroxide. Then, for example, a treatment for removing inorganic impurities on the surface of the support 10 is performed. In this treatment, for example, the support 10 is immersed in a strong acid solution such as nitric acid. Between the treatments, the support 10 may be washed with water. Between the treatments, a drying treatment of the support 10 may be performed by blowing the support 10 with an inert gas such as nitrogen gas. For example, the support 10 having undergone the above preparation treatment is used in the step S1.

In the step S1, for example, the support 10 is subjected to electroless zinc plating. Since aluminum is a base metal in relation to zinc, displacement electroless plating can be performed as the electroless zinc plating. A plating solution for the electroless zinc plating contains, for example, a zinc ion and a base such as sodium hydroxide. Since containing the base, the plating solution is alkaline and thus dissolves zinc. The plating solution for the electroless zinc plating is, for example, strong alkaline. Thus, the natural oxide formed on the support 10 by contact with air can be removed. The plating solution for the electroless zinc plating may contain various additives to increase the quality of the intermediate layer 20 being a plating film. A half-reaction formula of the electroless zinc plating of the support 10 is shown below.

Dissolution of aluminum (anodic reaction): Al + 4OH⁻ → [Al(OH)₄]⁻ + 3e⁻

Deposition of zinc (cathodic reaction): Zn²⁺ + 2e⁻ → Zn

A double zincate treatment may be performed in the step S1. In the double zincate treatment, the support 10 is immersed in an electroless zinc plating bath for a given period of time and is then immersed in nitric acid to dissolve a plating film formed of pure zinc on the surface of the support 10. Subsequently, the support 10 is further immersed in an electroless zinc plating bath. This is likely to form the intermediate layer 20 uniformly. A thickness of the intermediate layer 20 is adjusted, for example, in the range of 5 nm to 40 nm. In the double zincate treatment, the support 10 may be washed with water between the stages. A drying treatment of the support 10 may be performed between the stages by blowing the support 10 with an inert gas such as nitrogen gas. After the step S1, the support 10 may be washed with water. After the step S1, a drying treatment of the support 10 may be performed by blowing the support 10 with an inert gas such as nitrogen gas.

Next, in the step S2, the support 10 having the intermediate layer 20 thereon is subjected to electroless bismuth plating. Since zinc is a base metal in relation to bismuth, displacement electroless plating can be performed as the electroless bismuth plating. A plating solution for the electroless bismuth plating contains, for example, a bismuth ion, a pH adjuster, a complexing agent, and a tin(II) ion.

A water-insoluble bismuth hydroxide can be generated from bismuth under an alkaline condition. To prevent this, the pH of a plating solution for the electroless bismuth plating is adjusted to be acidic. Zinc is an amphoteric metal, and can dissolve in an acidic range where pH < 6.5 is satisfied. Even zinc oxide forming a natural oxide of a surface of the intermediate layer 20 is thought to be soluble in this pH range. Bismuth dissolves sufficiently under a strong acid condition. On the other hand, in the case of a bismuth ion alone under a weak acid condition, the bismuth ion solubility is so low that it is difficult to perform electroless plating. With a complexing agent in the plating solution, a bismuth ion dissolves under a weak acid condition such that electroless plating can be performed. In this case, the weakly acidic plating solution can hinder progress of dissolution of zinc included in the intermediate layer 20 and can prevent loss of the intermediate layer 20. Consequently, a decrease in adherence of the metal layer 31 in the resulting multilayer body can be prevented. The complexing agent is, for example, citric acid.

In the case where the plating solution contains a tin(II) ion, autocatalytic electroless plating can be performed as the electroless bismuth plating. In this case, a thickness of the metal layer 31 can be adjusted to 2 µm or more. In the step S2, metal bismuth formed by displacement electroless plating functions as a catalytic point, and a bismuth ion is reduced by an electron emitted by oxidation of the tin(II) ion into a tin(IV) ion to cause bismuth to deposit. As a result, the metal layer 31 is formed. A half-reaction formula of the electroless bismuth plating is shown below. After the step S2, the support 10 may be washed with water. After the step S2, a drying treatment of the support 10 may be performed by blowing the support 10 with an inert gas such as nitrogen gas.

Dissolution of zinc (anodic reaction): Zn → Zn²⁺ + 2e⁻

Deposition of bismuth (cathodic reaction): Bi³⁺ + 3e⁻ → Bi

Oxidation of tin(II) ion (anodic reaction): Sn²⁺ → Sn⁴⁺ + 2e⁻

The pH of the plating solution for the electroless bismuth plating is desirably 4 to 6. In particular, in the case where the pH of the plating solution is 5, the plating solution has a high stability and the metal layer 31 is likely to have a desired adherence. Moreover, in that case, a layer of pure bismuth is likely to be formed continuously in an in-plane direction. The thickness of the metal layer 31 increases in proportion to the time of the immersion of the support 10 in the plating solution. The thickness of the metal layer 31 may be, for example, 0.1 µm to 20 µm, or 2 µm to 20 µm.

Aluminum is a base metal in relation to tin and lead, while tin and lead are base metals in relation to bismuth. Moreover, tin and lead are amphoteric metals as zinc is. Therefore, a multilayer body can be produced by electroless plating also when the intermediate layer 20 includes tin or lead.

The method for producing each of the multilayer bodies 1b, 1c, 1d, and 1e further includes forming the oxide layer 32. The oxide layer 32 can be formed by oxidization of at least the surface of the metal layer 31. The metal layer 31 may be partly oxidized, or the whole metal layer 31 may be oxidized.

The method for oxidizing the surface of the metal layer 31 for formation of the oxide layer 32 is not limited to a particular method. For example, the oxide layer 32 can be formed by anodic oxidation. For example, in an alkaline electrolyte solution where pH > 8.5 is satisfied and bismuth oxide does not dissolve, a DC voltage is applied between an anode being a multilayer body including the support 10, the intermediate layer 20, and the metal layer 31 and a cathode being a platinum foil. This results in anodic oxidation of the surface of the metal layer 31, and the oxide layer 32 can be formed thereby. The application of the DC voltage includes, for example: increasing a level of the voltage to a given voltage level by constant-current drive; and applying the given level of the voltage for a given period of time by constant-voltage drive after the given voltage level is reached.

The electrolyte solution used in the anodic oxidation contains, for example, an alkaline salt such as sodium hydroxide and sodium borate. Because of this, the electrolyte solution serves as a buffer solution and has a stable pH. In addition to that, boron can be taken into the oxide layer 32 in the anodic oxidation. This hinders crystallization of bismuth oxide in the oxide layer 32, and tends to make the oxide layer 32 amorphous. When the oxide layer 32 is amorphous, current leakage is likely to be reduced in a capacitor in which the oxide layer 32 functions as a dielectric. The electrolyte solution may contain an oxoacid salt such as a phosphate or a silicate.

A thickness of the oxide layer 32 can be adjusted by, for example, the magnitude of the DC voltage applied in the anodic oxidation. The thickness of the oxide layer 32 is in proportion to, for example, the magnitude of the DC voltage applied in the anodic oxidation. For example, the thickness of the oxide layer 32 is adjusted equal to or smaller than the thickness of the metal layer 31 formed in the step S2.

The support 10 may include an aluminum alloy. It is possible to perform the electroless zinc plating of the support 10 also in this case. The aluminum alloy includes, for example, aluminum as its main component. Herein, the term "main component" refers to a component whose content is highest in terms of mass.

The intermediate layer 20 may include pure tin and/or pure lead. The intermediate layer 20 may include a zinc alloy, a tin alloy, and/or a lead alloy. The zinc alloy, the tin alloy, and the lead alloy are, for example, alloys capable of undergoing a eutectoid reaction by electroless plating, and respectively include zinc, tin, and lead as their main components.

The metal layer 31 may include a bismuth alloy. The bismuth alloy is, for example, an alloy capable of undergoing a eutectoid reaction by electroless bismuth plating. The bismuth alloy includes, for example, bismuth as its main component. In this case, the oxide layer 32 can include a composite oxide including bismuth due to oxidation of the bismuth alloy. For example, in the case where the metal layer 31 includes a bismuth-antimony alloy, the oxide layer 32 can include bismuth-antimony oxide.

The method for producing the multilayer body 1d may further include, for example, providing the surface of the metal layer 31 with asperities. This allows the metal layer 31 to have a larger surface area.

The capacitor 2 can be produced, for example, by disposing the electrode 50 on any of the multilayer bodies 1b, 1c, 1d, and 1e.

The multilayer bodies 1a, 1b, 1c, 1d, and 1e can also be used as solder. For example, the multilayer bodies 1a, 1b, 1c, 1d, and 1e can be provided as a member in which a lead-free bismuth solder having a low melting point is placed on an inexpensive aluminum substrate. The multilayer bodies 1a, 1b, 1c, 1d, and 1e can also be used as catalysts, electrodes such as electrodes in batteries, and precursors of other functional materials.

### EXAMPLES

Hereinafter, the present disclosure will be described in more detail with reference to an example. The example given below is just an example, and the present disclosure is not limited to the example.

### (Example)

A 0.5 mm-thick flat aluminum plate provided by Nippon Light Metal Company, Ltd. was cut to a rectangular with a short side length of 1 cm and a long side length of 4 cm to obtain an aluminum support. The support was subjected to a degreasing treatment by ultrasonic cleaning in acetone for 10 minutes. The degreasing-treated support was washed with pure water, and then dried by nitrogen blow. Next, the temperature of an aqueous solution mixture containing sodium hydroxide and sodium gluconate was adjusted to 60°C, and the support was subjected to an alkaline treatment by immersing the support in the aqueous solution mixture for 30 seconds. The sodium hydroxide concentration in the aqueous solution was 1.0 mol/liter (L), and the sodium gluconate concentration was 0.045 mol/L. The alkali-treated support was washed with pure water and dried by nitrogen blow. Next, the support was subjected to an acid treatment by immersing the support in 6.5 mol/L nitric acid at room temperature for 30 seconds. The acid-treated support was washed with pure water and dried by nitrogen blow. A support to be used for electroless zinc plating was prepared in this manner.

An undiluted zincate solution K-102 manufactured by JAPAN KANIGEN CO., LTD. was diluted twofold with pure water to prepare a plating solution for electroless zinc plating. An end of the support prepared in the above manner was clipped and hanged. For electroless zinc plating, the support in this condition was immersed in 30 mL of the plating solution such that the area of a surface to be plated by the plating solution was about 5 cm². A first zincate treatment was performed in which the support was immersed in the plating solution at room temperature for 20 seconds. Afterwards, the support was washed with pure water and dried by nitrogen blow. Next, the support was immersed in 6.5 mol/L nitric acid at room temperature for 30 seconds to dissolve the metal zinc layer adhered to the surface of the support. Afterwards, the support was washed with pure water and dried by nitrogen blow. Subsequently, a second zincate treatment was performed by immersing the support in the plating solution at room temperature for 2 minutes. Afterwards, the support was washed with pure water and dried by nitrogen blow. A plating film including pure zinc was formed on the support in this manner. Although an accurate thickness of this plating film was unable to be measured, the thickness of this plating film is supposed to be several nanometers to several tens of nanometers.

Sodium citrate, nitrilotriacetic acid, and sodium chloride were added into a solution obtained by dissolving bismuth oxide in nitric acid. After that, the solution was heated to 60°C to obtain a homogeneous solution. Subsequently, the solution was cooled to room temperature. An aqueous sodium hydroxide solution was added to the solution to adjust the pH of the solution. Finally, tin(II) sulfate was added to the solution to obtain a plating solution for electroless bismuth plating. In the plating solution, the bismuth oxide concentration was 0.03 mol/L, the nitric acid concentration was 1.3 mol/L, and the tin(II) sulfate concentration was 0.03 mol/L. In the plating solution, the sodium citrate concentration was 0.23 mol/L, the nitrilotriacetic acid concentration was 0.13 mol/L, the sodium chloride concentration was 0.13 mol/L, and the sodium hydroxide concentration was 1.29 mol/L. The pH of the plating solution was 5.1. The plating solution was heated to 60°C. The support on which the plating film including pure zinc was formed was immersed in the plating solution for 21 minutes. Afterwards, the support was washed with pure water and dried by nitrogen blow. A bismuth-including layer being a plating film including pure bismuth was formed in this manner on the plating film including pure zinc to obtain a first multilayer body according to Example. The bismuth-including layer of the first multilayer body had a thickness of about 2 µm.

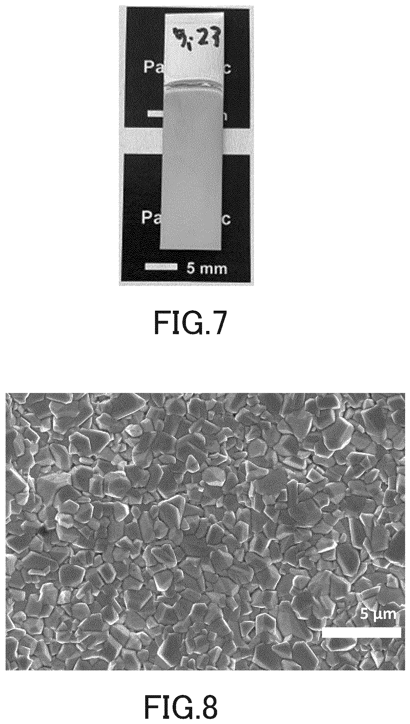

FIG. 7 is a photograph showing the first multilayer body according to Example. An upper portion of an approx. 1 cm² region of the plate-shaped first multilayer body shown in the photograph in FIG. 7 is not plated. Aluminum is exposed in this region and the color of the region is silver white. In a middle portion and a lower portion of the first multilayer body, the plating film including pure zinc and the bismuth-including layer are placed on the support. FIG. 8 is a SEM image of a surface of the bismuth-including layer of the first multilayer body. It is confirmed that, as shown in FIG. 8, pure bismuth particles having a diameter of several micrometers are continuously spread in an in-plane direction.

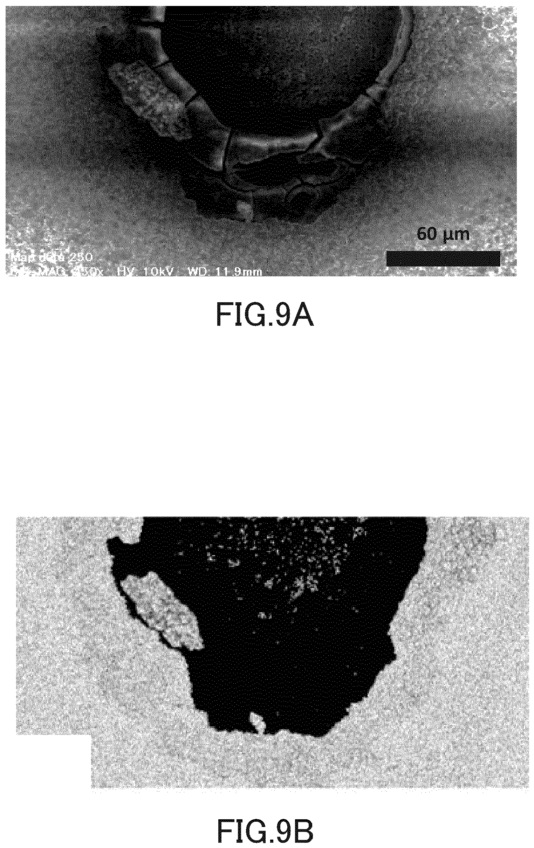

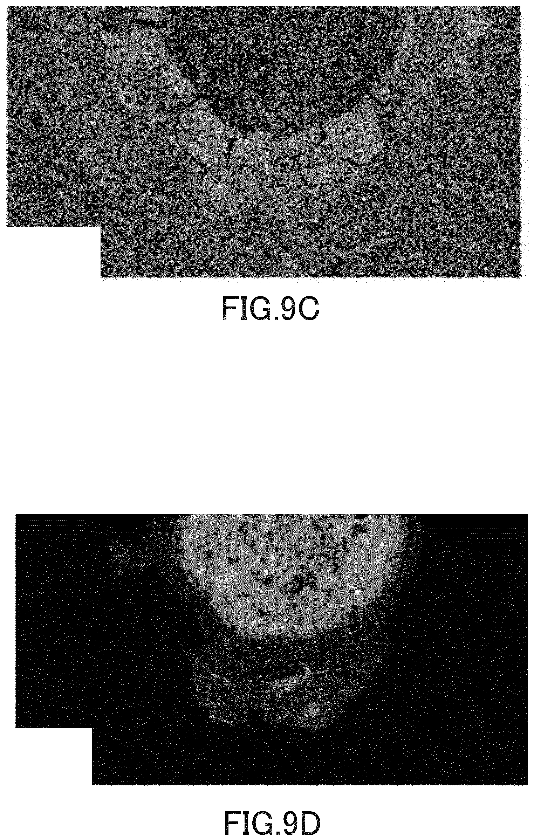

For observation of the multilayer structure of the first multilayer body, a portion of the first multilayer body was broken to obtain a rupture portion. SEM-EDX measurement was performed for the rupture portion and its vicinity. FIG. 9A is a SEM image showing the rupture portion of the first multilayer body according to Example and its vicinity. FIG. 9B is a mapping image showing a distribution of bismuth in the image shown in FIG. 9A, the distribution being obtained from the SEM-EDX measurement result. FIG. 9C is a mapping image showing a distribution of zinc in the image shown in FIG. 9A, the distribution being obtained from the SEM-EDX measurement result. FIG. 9D is a mapping image showing a distribution of aluminum in the image shown in FIG. 9A, the distribution being obtained from the SEM-EDX measurement result. In each mapping image, the concentration of each element is relatively high in a white portion. As can be understood from FIG. 9B, bismuth is present around the semicircular rupture portion, and the bismuth-including layer is present in an outermost surface of the first multilayer body. It seems from FIG. 9C that zinc is present all over the rupture portion and its vicinity because a SEM-EDX signal is weak due to a small abundance of zinc. However, closer observation reveals that zinc is largely distributed in a portion where cracks are confirmed, the portion being around the ruptured portion. It is therefore understood that zinc is present between the support and the bismuth-including layer. In FIG. 9D, the distribution of aluminum is confirmed in the rupture portion where the bismuth-including layer and the zinc plating film fell off.

A small amount of an aqueous sodium hydroxide solution was added into a 0.12 mol/L aqueous sodium tetraborate solution to prepare 100 milliliters (mL) of a buffer solution whose pH was adjusted to 10. The first multilayer body was hanged such that a portion of the first multilayer body was immersed in the buffer solution in a beaker. A portion which is part of the first multilayer body and to which the support was exposed was clipped, and was electrically connected to a positive terminal of a power source. A platinum electrode having a large surface area was immersed in the buffer solution at a distant from the first multilayer body, and was electrically connected to a negative terminal of the power source. A DC voltage was applied between the first multilayer body and the platinum electrode at room temperature using the power source, so that the first multilayer body functioned as an anode and the platinum electrode functioned as a cathode. The power source was in operation in constant current mode at 0.25 mA/cm² during a period in which the DC voltage varied from 0 V to 25 V. After the DC voltage reached 25 V, the power source was in operation in constant-voltage mode at 25 V for 10 minutes. The first multilayer body was subjected to an anodic oxidation treatment in this manner to obtain a second multilayer body according to Example including a bismuth anodic film.

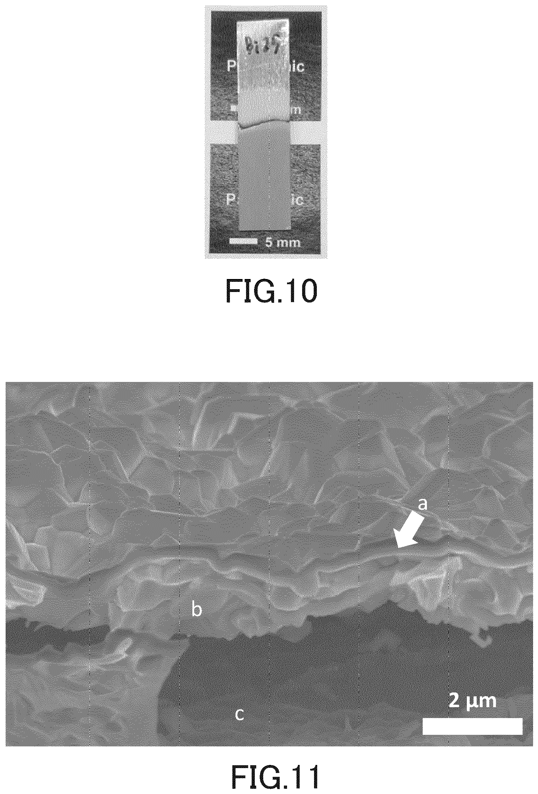

FIG. 10 is a photograph showing the second multilayer body according to Example. In FIG. 10, the bismuth anodic film is formed in a dark gray lower portion of the second multilayer body. This portion is actually pink. A portion of the second multilayer body was broken to obtain a rupture face. FIG. 11 is a SEM image of the rupture face of the second multilayer body according to Example viewed in an obliquely downward direction. In FIG. 11, as indicated by a white arrow a, a continuous coating is confirmed on a surface of the second multilayer body. It is understood that this coating is the bismuth anodic film. According to FIG. 11, the bismuth anodic film has a thickness of about 230 nm. In FIG. 11, a portion indicated by a reference character b is a layer including pure bismuth, and a portion indicated by a reference character c is the aluminum support.

Specimens produced from the support, the first multilayer body, and the second multilayer body according to Example were analyzed by X-ray diffraction (XRD) to obtain XRD patterns by 2θ/θ scan. In the XRD analysis, a Cu-Kα was used as an X-ray source, a voltage was adjusted to 40 kV, a current was adjusted to 30 mA, and a scanning rate was adjusted to 12 deg/min.

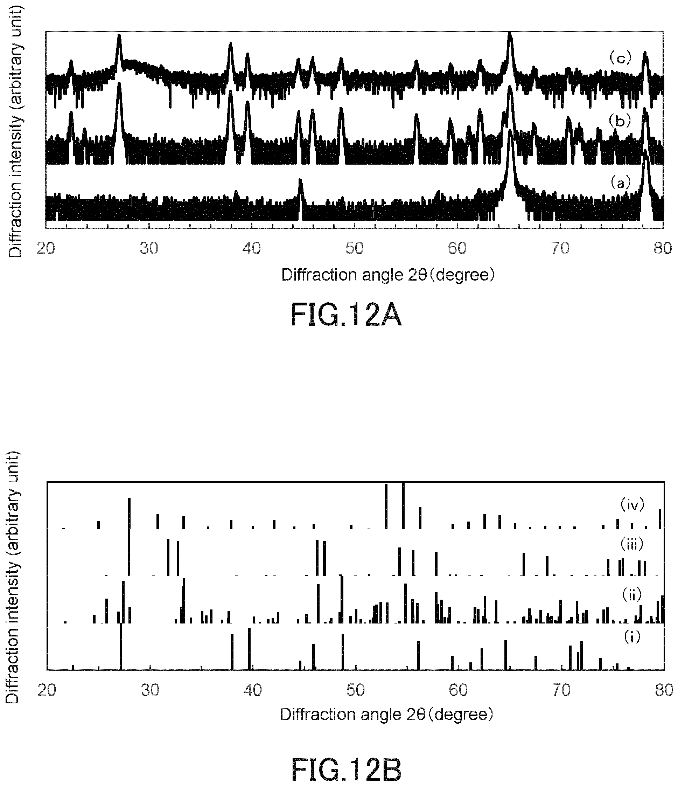

FIG. 12A shows XRD patterns of surfaces of the support, the first multilayer body, and the second multilayer body according to Example. In FIG. 12A, an XRD pattern (a) is the XRD pattern of the surface of the support, an XRD pattern (b) is the XRD pattern of the surface of the first multilayer body, and an XRD pattern (c) is the XRD pattern of the surface of the second multilayer body. In FIG. 12A, the vertical axis represents the diffraction intensity, while the horizontal axis represents the diffraction angle 2θ. FIG. 12B shows estimation results for XRD patterns of pure bismuth and bismuth oxides, the estimation results being produced with reference to a literature. In FIG. 12B, an XRD pattern (i) is the estimation result for pure bismuth, and XRD patterns (ii), (iii), and (iv) are respectively the estimation results for α-Bi₂O₃, β-Bi₂O₃, and δ-Bi₂O₃. Comparison between FIG. 12A and FIG. 12B reveals that the bismuth-including layer including pure bismuth is polycrystalline. On the other hand, in the XRD pattern (c) in FIG. 12A, a peak corresponding to a bismuth oxide is not present, and a halo pattern is confirmed in a diffraction angle 2θ range of 25° to 33°. These reveal that the bismuth anodic film is an amorphous phase.

A platinum electrode was formed on the bismuth anodic film of the second multilayer body by electron beam evaporation with a surface of the second multilayer body covered by a metal mask having a 400 µm-diameter hole. A capacitor according to Example was produced in this manner. A portion of the surface of the second multilayer body was ground using a file to expose the aluminum of the support. The exposed aluminum portion and the platinum electrode were connected to an LCR meter to measure the capacity in an environment at 25°C. In this measurement, a DC voltage was adjusted to 0 V, and an AC voltage was adjusted to 0.1 V.

### (Reference Example)

A flat plate made of pure bismuth and provided by The Nilaco Corporation was subjected to an anodic oxidation treatment in the same manner as in Example, except that the flat plate made of pure bismuth was used instead of the first multilayer body according to Example. In this case, the resulting bismuth anodic film had a thickness of about 250 nm. A platinum electrode was formed on the bismuth anodic film by electron beam evaporation with the anodic-oxidation-treated flat plate covered by a metal mask having a 400 µm-diameter hole. A capacitor according to Reference Example was produced in this manner. The flat plate was ground using a file to expose the bismuth of the support. The exposed bismuth portion and the platinum electrode were connected to an LCR meter to measure the capacity in an environment at 25°C. In this measurement, a DC voltage was adjusted to 0 V, and an AC voltage was adjusted to 0.1 V.

### (Comparative Example)

A flat aluminum plate was subjected to an anodic oxidation treatment in the same manner as in Example, except that the flat aluminum plate was used instead of the first multilayer body according to Example and a 0.1 mol/L aqueous ammonium adipate solution was used instead of the buffer solution. In this case, the resulting aluminum anodic film had a thickness of about 243 nm. A platinum electrode was formed on the aluminum anodic film by electron beam evaporation with the anodic-oxidation-treated flat plate covered by a metal mask having a 400 µm-diameter hole. A capacitor according to Comparative Example was produced in this manner. The flat plate was ground using a file to expose the aluminum of the support. The exposed aluminum portion and the platinum electrode were connected to an LCR meter to measure the capacity in an environment at 25°C. In this measurement, a DC voltage was adjusted to 0 V, and an AC voltage was adjusted to 0.1 V.

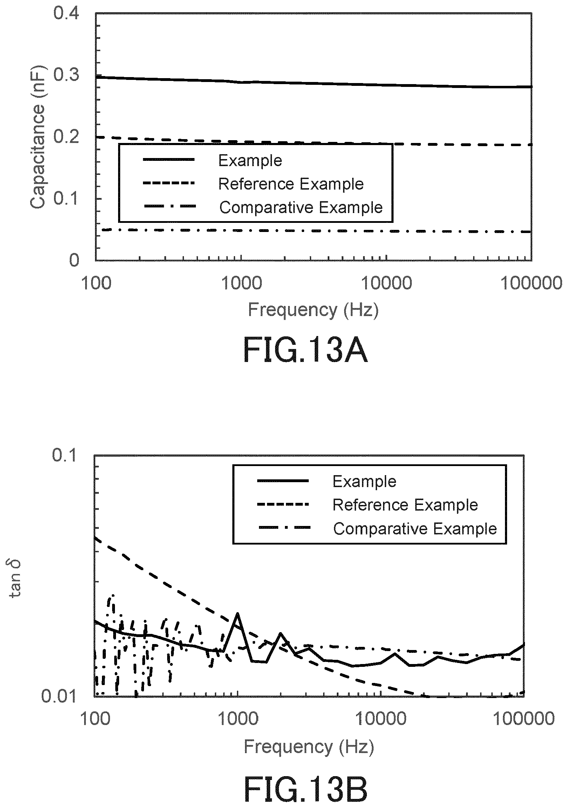

FIG. 13A is a graph showing a relation between a capacitance of each of the capacitor according to Example, the capacitor according to Reference Example, and the capacitor according to Comparative Example and a frequency. In FIG. 13A, the vertical axis represents the capacitance, while the horizontal axis represents the frequency of the AC voltage applied to each capacitor. FIG. 13B is a graph showing a relation between a dielectric loss tanδ of each of the capacitor according to Example, the capacitor according to Reference Example, and the capacitor according to Comparative Example and the frequency. In FIG. 13B, the vertical axis represents the dielectric loss tanδ, while the horizontal axis represents the frequency of the AC voltage applied to each capacitor. The dielectric constant of the aluminum anodic film was determined on the basis of the result of measuring the capacity of the capacitor according to Comparative Example. The aluminum anodic film had a dielectric constant of approximately 8. The dielectric constant of the bismuth anodic film was determined on the basis of the result of measuring the capacity of the capacitor according to Reference Example. The bismuth anodic film had a dielectric constant of approximately 40. As shown in FIG. 13A, the capacity of the capacitor according to Reference Example is about 5 times higher than the capacity of the capacitor according to Comparative Example. As shown in FIG. 13A, the capacity of the capacitor according to Example is higher than the capacity of the capacitor according to Reference Example. This is thought to be attributable to a large effective surface area of the bismuth anodic film owing to surface roughness of the bismuth-including layer of the second multilayer body. For the capacitor according to Example and the capacitor according to Reference Example, the dielectric loss tanδ is 0.1 or less; it has been confirmed that the bismuth anodic film of the second multilayer body is useful as a dielectric of a capacitor.

### INDUSTRIAL APPLICABILITY

The multilayer body according to the present disclosure is useful as electrodes, particularly anodes, of capacitors such as electrolytic capacitors requiring a high capacity. Moreover, the multilayer body according to the present disclosure can be easily produced by the multilayer body production method according to the present disclosure.

## Claims

1. A method for producing a multilayer body, the method comprising:
forming an intermediate layer on a support; and
forming a metal layer on the intermediate layer by electroless plating, the metal layer including at least one selected from the group consisting of pure bismuth and a bismuth alloy, wherein
the intermediate layer includes at least one selected from the group consisting of pure zinc, a zinc alloy, pure tin, a tin alloy, pure lead, and a lead alloy.

2. The method according to claim 1, wherein the support includes at least one selected from the group consisting of pure aluminum and an aluminum alloy.

3. The method according to claim 1 or 2, further comprising forming the intermediate layer on the support by electroless plating.

4. The method according to any one of claims 1 to 3, further comprising forming an oxide layer by oxidation of at least a surface of the metal layer, the oxide layer including at least one selected from the group consisting of bismuth oxide and a composite oxide including bismuth.

5. The method according to any one of claims 1 to 4, further comprising providing a surface of the metal layer with asperities.

6. A method for producing a capacitor, the method comprising:
preparing a multilayer body, the multilayer body including a support, an intermediate layer, and a dielectric layer in this order,
disposing an electrode on the multilayer body, wherein
the dielectric layer includes at least one selected from the group consisting of bismuth oxide and a composite oxide including bismuth, and
the intermediate layer includes at least one selected from the group consisting of pure zinc, a zinc alloy, pure tin, a tin alloy, pure lead, and a lead alloy and is disposed between the dielectric layer and the support in a thickness direction of the dielectric layer.

7. The method according to claim 6, wherein the support includes at least one selected from the group consisting of pure aluminum and an aluminum alloy.

8. A multilayer body comprising:
a support;
a bismuth-including layer including at least one selected from the group consisting of pure bismuth, a bismuth alloy, bismuth oxide, and a composite oxide including bismuth; and
an intermediate layer including at least one selected from the group consisting of pure zinc, a zinc alloy, pure tin, a tin alloy, pure lead, and a lead alloy, the intermediate layer being disposed between the bismuth-including layer and the support in a thickness direction of the bismuth-including layer.

9. The multilayer body according to claim 8, wherein the support includes at least one selected from the group consisting of pure aluminum and an aluminum alloy.

10. The multilayer body according to claim 8 or 9, wherein the bismuth-including layer includes at least one selected from the group consisting of pure bismuth and a bismuth alloy.

11. The multilayer body according to any one of claims 8 to 10, wherein the bismuth-including layer includes at least one selected from the group consisting of bismuth oxide and a composite oxide including bismuth.

12. The multilayer body according to any one of claims 8 to 11, wherein the bismuth-including layer includes: an oxide layer including at least one selected from the group consisting of bismuth oxide and a composite oxide including bismuth; and a metal layer including at least one selected from the group consisting of pure bismuth and a bismuth alloy, the metal layer being disposed between the oxide layer and the intermediate layer in a thickness direction of the oxide layer.

13. The multilayer body according to any one of claims 8 to 12, wherein the multilayer body has an uneven structure including the bismuth-including layer.

14. The multilayer body according to any one of claims 8 to 13, wherein the bismuth-including layer is an electroless plating film.

15. The multilayer body according to any one of claims 8 to 14, wherein the intermediate layer is an electroless plating film.

16. A capacitor comprising:
the multilayer body according to any one of claims 8 to 15; and
an electrode disposed on the bismuth-including layer, wherein
the bismuth-including layer includes an oxide layer including at least one selected from the group consisting of bismuth oxide and a composite oxide including bismuth.

17. An electrical circuit comprising the capacitor according to claim 16.

18. A circuit board comprising the capacitor according to claim 16.

19. An apparatus comprising the capacitor according to claim 16.
